Europäisches Patentamt

European Patent Office

Office européen des brevets

(19)

(11) **EP 1 038 301 B1**

(12) **EUROPÄISCHE PATENTSCHRIFT**

(45) Veröffentlichungstag und Bekanntmachung des Hinweises auf die Patenterteilung:
**07.08.2002 Patentblatt 2002/32**

(21) Anmeldenummer: **98964376.2**

(22) Anmeldetag: **02.12.1998**

(51) Int Cl.$^7$: **H01B 12/04**

(86) Internationale Anmeldenummer:
**PCT/DE98/03554**

(87) Internationale Veröffentlichungsnummer:
**WO 99/30332 (17.06.1999 Gazette 1999/24)**

(54) **VERFAHREN ZUR HERSTELLUNG EINES BANDFÖRMIGEN SUPRALEITERS MIT HOCH-Tc-SUPRALEITERMATERIAL**

METHOD FOR PRODUCING A BAND-SHAPED SUPRACONDUCTOR WITH HIGH Tc SUPRACONDUCTIVE MATERIAL

PROCEDE POUR PRODUIRE UN SUPRACONDUCTEUR EN FORME DE BANDE AVEC UN MATERIAU SUPRACONDUCTEUR PRESENTANT UN POINT ELEVE (Tc) DE CHANGEMENT BRUSQUE DE LA CONDUCTIVITE

(84) Benannte Vertragsstaaten:
**DE FR GB IT**

(30) Priorität: **09.12.1997 DE 19754669**

(43) Veröffentlichungstag der Anmeldung:
**27.09.2000 Patentblatt 2000/39**

(73) Patentinhaber: **SIEMENS AKTIENGESELLSCHAFT
80333 München (DE)**

(72) Erfinder:
• **KAUTZ, Stefan
D-90607 Rückersdorf (DE)**
• **FISCHER, Bernhard
D-63486 Bruchköbel (DE)**
• **ROAS, Bernhard
D-89520 Heidenheim (DE)**
• **KÜHNL, Manfred
D-91336 Heroldsbach (DE)**

(74) Vertreter: **Westphal, Klaus, Dipl.-Ing.
Patentanwälte
Westphal, Mussgnug & Partner,
Waldstrasse 33
78048 Villingen-Schwenningen (DE)**

(56) Entgegenhaltungen:
**US-A- 5 208 215         US-A- 5 399 312**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die Erfindung bezieht sich auf ein Verfahren zur Herstellung eines langgestreckten, bandförmigen Supraleiters mit mindestens einem Leiterkern, welcher ein Supraleitermaterial mit einer metalloxidischen Hoch-$T_c$-Phase aufweist und von einem normalleitenden Material umgeben ist, bei welchem Verfahren ein Leitervorprodukt mit einem von dem normalleitenden Material umgebenen, pulverförmigen Vormaterial des Supraleitermaterials erstellt wird und das Leitervorprodukt mehreren querschnittsvermindernden, das Vormaterial verdichtenden Verformungsschritten, die wenigstens zwei Flachbearbeitungsschritte umfassen, und mindestens einer Glühbehandlung unterzogen wird. Ein entsprechendes Herstellungsverfahren und ein damit hergestellter Supraleiter gehen z.B. aus der Veröffentlichung *"Physica C"*, *Vol. 250, 1995, Seiten 340 bis 348* hervor.

Es sind supraleitende Metalloxidverbindungen mit hohen Sprungtemperaturen $T_c$ von über 77 K bekannt, die deshalb auch als Hoch-$T_c$-Supraleitermaterialien oder HTS-Materialien bezeichnet werden und insbesondere eine Flüssig-Stickstoff(LN$_2$)-Kühltechnik erlauben. Unter solchen Metalloxidverbindungen fallen insbesondere Cuprate von speziellen Stoffsystemen wie insbesondere von selten-erd-haltigen Basistyp Y-Ba-Cu-O oder der selten-erd-freien Basistypen Bi-Sr-Ca-Cu-O oder (Bi,Pb)-Sr-Ca-Cu-O. Innerhalb einzelner Stoffsysteme wie z.B. der Bi-Cuprate können mehrere supraleitende Hoch-$T_c$-Phasen auftreten, die sich durch die Anzahl der Kupfersauerstoff-Netzebenen bzw. -Schichten innerhalb der kristallinen Einheitszellen unterscheiden und die verschiedene Sprungtemperaturen $T_c$ aufweisen.

Mit den bekannten HTS-Materialien wird versucht, langgestreckte Supraleiter in Draht- oder Bandform herzustellen. Ein hierfür als geeignet angesehenes Verfahren ist die sogenannte "Pulver-im-Rohr-Technik", die prinzipiell von der Herstellung von Supraleitern mit dem klassischen metallischen Supraleitermaterial Nb$_3$Sn her bekannt ist. Entsprechend dieser Technik wird auch zur Herstellung von Leitern aus HTS-Material in eine rohrförmige Umhüllung bzw. in eine Matrix aus einem normalleitenden Material, insbesondere aus Ag oder einer Ag-Legierung, ein im allgemeinen pulverförmiges Vormaterial des HTS-Materials eingebracht, das im allgemeinen noch nicht oder nur zu einem geringen Teil die gewünschte supraleitende Hoch-$T_c$-Phase enthält. Das so zu erhaltende Leitervorprodukt wird anschließend mittels Verformungsbehandlungen, die gegebenenfalls durch mindestens eine Wärmebehandlung bei erhöhter Temperatur unterbrochen sein können, auf die gewünschte Enddimension gebracht. Danach wird das so erhaltene Leiterzwischenprodukt zur Einstellung oder Optimierung seiner supraleitenden Eigenschaften bzw. zur Ausbildung der gewünschten Hoch-$T_c$-Phase mindestens einer Glühbehandlung unterzogen, die gegebenenfalls durch einen weiteren Verformungsschritt unterbrochen sein kann.

Bündelt man in an sich bekannter Weise entsprechende Hoch-$T_c$-Supraleiter oder deren Leitervorprodukte oder deren Leiterzwischenprodukte, so kann man auch Leiter mit mehreren supraleitenden Leiterkernen, sogenannte Mehrkern- oder Multifilamentsupraleiter, erhalten.

Die bekannten Ein- oder Mehrkernsupraleiter mit HTS-Material haben bevorzugt eine Bandform. Um diese Form eines entsprechenden Leiterendproduktes zu erhalten, muß gemäß der eingangs genannten Literaturstelle ein Walzprozeß vorgesehen werden. Vor diesem Walzprozeß muß jedoch aus dem Leitervorprodukt ein im allgemeinen zylinderförmiger, vorverformter und vorverdichteter Verbundkörper erstellt werden mit einer im allgemeinen gleichverteilten Anordnung von Leiterkernen über den Querschnitt gesehen. Dieser nachfolgend als Rohleiter bezeichnete Verbundkörper wird dann mittels des mehrere Walzschritte umfassenden Walzprozesses in die flache Bandform überführt, um so eine für eine hohe Stromtragfähigkeit notwendige Textur, d.h. eine weitgehend parallele Ausrichtung der Kristallebenen der supraleitenden Phase, zu erreichen. Hierzu muß das Vormaterial des Supraleiters bei der Umformung des Rohleiters durch den Walzprozeß möglichst stark verdichtet werden. Es zeigt sich jedoch, daß ab einer gewissen Pulverdichte bei einer weiteren Umformung Inhomogenitäten wie z.B. das sogenannte "sausaging", das sind Ein- oder Abschnürungen des Leiterkerns über die Länge des Leiters gesehen, oder Risse auftreten. Somit ist der Verdichtung durch den Walzprozeß eine Grenze gesetzt.

Aus diesem Grunde wird bei dem aus der eingangs genannten Literaturstelle zu entnehmenden Verfahren nur so lange verdichtet, bis entsprechende Inhomogenitäten auftreten. In der Regel wird deshalb der Walzprozeß so durchgeführt, daß nach dem ersten Walzschritt mit dem nächsten Walzschritt eine zumindest weitgehend gleiche Reduktion der Dicke des einzelnen Leiterkerns bzw. prozentuale Dickenabnahme gewährleistet ist. Unter der Dickenabnahme sei hierbei die Größe $(d_i - d_{i+1})/d_i$ verstanden, wobei mit dem Index $i = 0, 1, 2 \ldots$ die Nummer des jeweiligen Walzschrittes und mit $d_i$ die Dicke des jeweiligen Leiterkerns nach dem i-ten Walzschritt bezeichnet sind. $d_0$ ist die Ausgangsdicke vor dem Walzen.

Bei dem aus der *EP 0 435 286 A* zu entnehmenden Verfahren zur Herstellung eines HTS-Bandleiters wird der Walzprozeß so durchgeführt, daß die Dickenabnahme bei einem auf einen ersten Walzschritt folgenden zweiten Walzschritt kleiner ist als bei dem vorhergehenden.

Aus der US A 5208215 ist ein Herstellungsverfahren bekannt welches die Flachbearbeitungsschritte beinhaltet.

Ein Auftreten von Inhomogenitaten durch einen verhinderten Pulverfluß während der Flachbearbeitungsschritte wird aber in der US A 5208215 nicht erwähnt.

Aufgabe der vorliegenden Erfindung ist es, das Verfahren mit den eingangs genannten Merkmalen dahingehend auszugestalten, daß die erwähnten Inhomogenitätsprobleme vermindert sind und damit eine höhere Stromtragfähigkeit des bandförmigen Supraleiters erhalten wird.

Diese Aufgabe wird erfindungsgemäß dadurch gelöst, daß ein auf einen vorhergehenden Flachbearbeitungsschritt folgender Flachbearbeitungsschritt derart vorzunehmen ist, daß die mit dem folgenden Flachbearbeitungsschritt erfolgte prozentuale Dickenabnahme des Querschnitts des mindestens einen Leiterkerns größer ist als die mit dem vorhergehenden Flachbearbeitungsschritt.

Mit den erfindungsgemäßen Maßnahmen wird also eine progressive Verdichtung des pulverförmigen Vormaterials erreicht; d.h., die prozentuale Dickenreduktion des mindestens einen Leiterkerns nimmt während der Rohleiterumformung zu. - Unter einem Rohleiter sei hier der Verbundkörper vor dem ersten Flachbearbeitungsschritt, insbesondere durch Walzen, verstanden -. Ausgangspunkt dieser Vorgehensweise ist die Tatsache, daß der Pulverfluß während der Rohleiterumformung möglichst lange aufrechterhalten bleiben muß, um so eine optimale Verdichtung des Pulvers zu erreichen. Behält man nämlich bei allen Walzschritten einen konstant niedrigen Umformungsgrad von z.B. 10 % bei, so wird sich nach wenigen Walzschritten ein quasi festgefahrener Zustand des pulverförmigen Vormaterials einstellen. D.h., die Pulverteilchen können sich dann aufgrund der Reibung untereinander nicht mehr bewegen, da die von außen aufgebrachte Kraft nicht mehr ausreicht, um die Reibungskräfte zu überwinden. Folglich wird ein Fließen des Pulvers unterbunden; die Pulverteilchen werden nur noch aufeinandergepreßt, wodurch Hohlräume erhalten bleiben und die Verdichtung stagniert. Bei einer konstant hohen Umformung wird das Pulver schon im ersten Schritt so stark verpreßt, daß bei weiterer Umformung Inhomogenitäten wie Risse oder Brüche auftreten. D.h., das Pulver ist dann nicht mehr fließfähig. Eine degressive Verdichtung wie sie z. B. gemäß der genannten EP-A-Schrift vorgesehen sein soll, bei der einem hohen Umformgrad nur noch niedrigere folgen, läßt dann die Verdichtung durch Pulverfluß schon nach dem ersten Walzschritt zum Stillstand kommen.

Demgegenüber wird mit den erfindungsgemäßen Maßnahmen eine progressive Verdichtung - bzw. Umformung erreicht. Somit läßt sich durch gesteigerte Umformkraft der vorher reibungsbedingte blockierte Zustand des Pulvers überwinden, was zu weiterem Fließen und Verdichten führen kann. Mit steigendem Umformgrad und erhöhter Dichte läßt sich so der Pulverfluß möglichst lange aufrechterhalten. Dies verhindert hohe partielle Verdichtungen und Mikrobrüche, die zu den vorerwähnten Inhomogenitäten führen, bevor die angestrebte Dichte des Leiterendproduktes erreicht wird.

Die mit den erfindungsgemäßen Maßnahmen erreichten Vorteile sind somit darin zu sehen, daß durch die gezielte Wahl der Verdichtungsparameter Inhomogenitäten erst bei wesentlich höheren Pulverdichten auftreten können und somit durch die gesteigerten homogenen Pulverdichten eine entsprechend größere Stromtragfähigkeit zu gewährleisten ist.

Besonders vorteilhaft wird das erfindungsgemäße Verfahren zur Herstellung eines Einkern-, vorzugsweise Mehrkernsupraleiters verwendet, dessen mindestens ein Leiterkern von einem normalleitenden Material umgeben ist, das Ag enthält oder aus Ag besteht. Die Ausbildung der supraleitenden Phase in einer sauerstoffhaltigen Atmosphäre wird so erleichtert.

Vorteilhafte Ausgestaltungen des erfindungsgemäßen Verfahrens gehen aus den jeweils abhängigen Ansprüchen hervor.

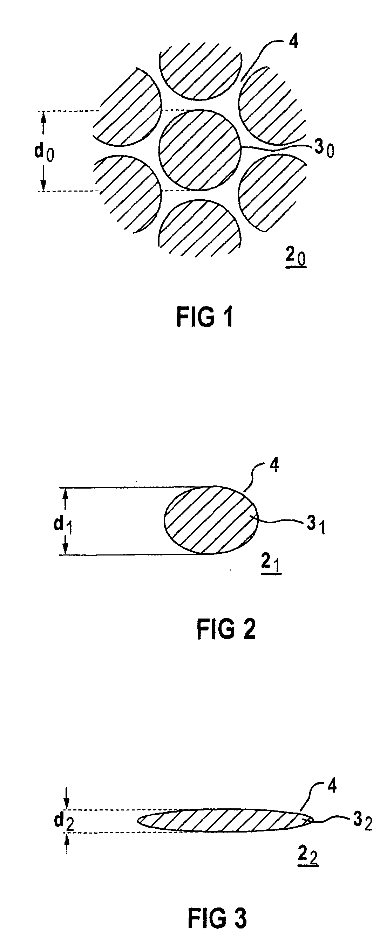

Die Erfindung wird nachfolgend anhand eines Ausführungsbeispiels noch weiter erläutert, wobei auf die Zeichnung Bezug genommen wird. Deren Figuren 1 bis 3 zeigen schematisch einen Leiterkern eines Rohleiters vor bzw. nach einer erfindungsgemäßen Flachbearbeitung.

Ein erfindungsgemäß hergestellter, nachfolgend als Leiterendprodukt bezeichneter Supraleiter stellt einen langgestreckten Verbundkörper in Bandform dar, der ein in ein normalleitendes Matrixmaterial eingebettetes Hoch-$T_c$-(HTS)-Supraleitermaterial wenigstens weitgehend phasenrein enthält. Als HTS-Material sind praktisch alle bekannten Hoch-$T_c$-Supraleitermaterialien, vorzugsweise selten-erd-freie Cuprate, mit Phasen geeignet, deren Sprungtemperatur $T_c$ über der Verdampfungstemperatur des flüssigen Stickstoffs ($LN_2$) von 77 K liegt. Ein entsprechendes Beispiel ist das HTS-Material vom Typ $(Bi, Pb)_2Sr_2Ca_2Cu_3O_x$, das nachfolgend als Ausführungsbeispiel angenommen ist. Zur Herstellung eines entsprechenden HTS-Leiters aus diesem Bi-Cuprat kann vorteilhaft eine an sich bekannte Pulver-im-Rohr-Technik zugrundegelegt werden (vgl. z. B. die *DE 44 44 937 A*). Hierzu wird ein pulverförmiges Vorproduktmaterial, das eine Ausbildung der gewünschten supraleitenden Phase ermöglicht, oder das bereits ausgebildete supraleitende Material in ein Hüllrohr eingebracht, dessen Material als Matrixmaterial für das fertige Endprodukt des Supraleiters dient. Für das Hüllrohr wählt man vorzugsweise ein Basismaterial, das bei der Leiterherstellung keine unerwünschte Reaktion mit den Komponenten des HTS-Materials wie mit Sauerstoff eingeht und das sich leicht verformen läßt. Deshalb ist als Basismaterial besonderes ein Ag-Material geeignet, das entweder Ag in reiner Form oder in Form einer Legierung mit Ag als Hauptbestandteil (d.h. zu mehr als 50 Gew.-%) enthält. So ist z.B. reines Ag beispielsweise in Form von kaltverfestigtem Silber oder rekristallisiertem Silber verwendbar. Auch kann pulvermetallurgisch hergestelltes Silber vorgesehen werden. Daneben ist auch dispersionsgehärtetes Silber geeignet.

Der Aufbau aus dem Hüllrohr und dem von ihm umschlossenen Kern z.B. aus dem Vorproduktmaterial des HTS-Materials kann anschließend einer Abfolge von mehreren insbesondere querschnittsvermindernden Verformungsschritten unterzogen werden, um einen Rohleiter zu erhalten. Für die Verformungsschritte kommen alle bekannten Verfahren wie z.B. Strangpressen, Gesenkschmieden, Hämmern, Ziehen oder Walzen in Frage (vgl. z.B. *EP 0 281 444 A*), die auch miteinander kombiniert sein können. Diese mechanischen Behandlungen können sowohl bei Raumtemperatur als auch bei erhöhter, gegebenenfalls aber auch bei tiefer Temperatur durchgeführt werden. Nach diesen Verformungsschritten liegt dann ein Rohleiter in Form eines Verbundkörpers mit im allgemeinen kreisförmiger, gegebenenfalls aber auch rechteckiger Querschnittsfläche vor. Dieser Verbundkörper wird anschließend noch einem mehrere Schritte umfassenden Flachbearbeitungsprozeß unterzogen, um so eine dem angestrebten Endprodukt zumindest weitgehend entsprechende Bandform zu erhalten. Außerdem muß noch mindestens eine Wärme- oder Glühbehandlung vorgenommen werden, die im allgemeinen am Ende des Flachbearbeitungsprozesses vorzugsweise in einer sauerstoffhaltigen Atmosphäre wie z.B. an Luft durchgeführt wird, um so dem Vorproduktmaterial in an sich bekannter Weise den für die Ausbildung der gewünschten supraleitenden Phase erforderlichen Sauerstoff zur Verfügung zu stellen oder die Wiederherstellung dieser Phase zu gewährleisten.

Das vorstehend beschriebene Verfahren kann nicht nur zur Herstellung von Einkernleitern dienen, sondern ist insbesondere auch zur Herstellung von Mehrkernleitern geeignet. Solche Mehrkern- bzw. Multifilamentleiter werden im allgemeinen mittels einer an sich bekannten Bündelungstechnik ausgebildet. Demgemäß ist z.B. eine Bündelung von mehreren Ausgangsprodukten, die jeweils aus einem Hüllrohr und einem darin befindlichen Kern aus dem Vorproduktmaterial bestehen, in einem größeren Hüllrohr aus dem Matrixmaterial möglich. Selbstverständlich können auch vorverformte und gegebenenfalls vorgeglühte Rohleiter oder andere Leiterzwischenprodukte in ein solches Hüllrohr eingebracht werden. Der so gewonnene Aufbau wird dann analog zum Einkernleiter weiterverarbeitet.

Der einen oder vorzugsweise mehrere Leiterkerne enthaltende Rohleiter wird anschließend einem Flachbearbeitungsprozeß, z.B. mittels Ziehens, Pressens, Hämmerns oder insbesondere mittels Walzens, unterzogen, um so die gewünschte Bandform zu erhalten. Der nachfolgend angenommene Walzprozeß soll dabei mindestens zwei Walzschritte umfassen. Gemäß der Erfindung ist der auf einen vorhergehenden (insbesondere ersten) Flachbearbeitungsschritt (vorzugsweise Walzschritt) folgende Flachbearbeitungsschritt derart vorzunehmen, daß die mit dem folgenden (insbesondere zweiten) Flachbearbeitungsschritt (vorzugsweise Walzschritt) erfolgte prozentuale Dickenabnahme des Querschnittes des mindestens einen Leiterkerns größer ist als die mit dem vorhergehenden Flachbearbeitungsschritt. Eine entsprechende progressive Umformung sei nachfolgend anhand der Figuren 1 bis 3 skizziert. Ausgegangen wird von einem Rohleiter $2_0$ mit wenigstens einem Leiterkern $3_0$ der Dicke (= Durchmesser) $d_0$ (vgl. Figur 1). Der Leiterkern $3_0$ sei dabei von einem normalleitenden Material (4) umgeben. Mittels eines ersten Walzschrittes wird dann dieser Rohleiter zu einem Rohleiter $2_1$ flachgearbeitet, wobei der nunmehr mit $3_1$ bezeichnete, flache Leiterkern eine Dicke $d_1$ hat (vgl. Figur 2). Es schließt sich dann ein zweiter Walzschritt an, um den flachgearbeiteten Rohleiter $2_1$ in einen noch flacheren Rohleiter $2_2$ zu überführen. Dessen Leiterkern $3_2$ hat dann eine Dicke $d_2$ (vgl. Figur 3). Es können sich noch weitere Walzschritte anfügen, an deren Ende ein bandförmiger Verbundkörper vorliegt, der noch mindestens einer Glühbehandlung unterzogen wird. Bei allen weiteren Walzschritten oder bei einigen dieser Walzschritte muß nicht unbedingt eine progressive Umformung erfolgen. Vorteilhaft ist es jedoch auf jeden Fall, wenn die progressive Umformung nicht erst am Ende, vorzugsweise zumindest am Anfang des gesamten Walzprozesses vorgenommen wird. Diese progressive Umformung läßt sich nach der Erfindung durch die folgende Ungleichung beschreiben:

$$\frac{d_0 - d_1}{d_0} < \frac{d_1 - d_2}{d_1}$$

D.h., nach dem ersten Walzschritt soll mindestens einer der folgenden Walzschritte, vorzugsweise der nächste, eine größere Dickenreduktion bewirken. Vorteilhaft wird mit dem folgenden Walzschritt eine um mindestens 5 % größere Dickenreduktion bewirkt. Vorzugsweise sollte die Zunahme der Dickenreduktion zwischen dem ersten Walzschritt und dem nachfolgenden oder einem der nachfolgenden Walzschritte mindestens 20 % betragen. Ferner wird zweckmäßig am Anfang des Walzprozesses eine verhältnismäßig geringe Dickenreduktion eingeplant. Im allgemeinen liegt diese Dickenreduktion zwischen 3 und 10 %.

Gemäß einem konkreten Ausführungsbeispiel wurde ein Ag/Bi-2223-Bandleiter mit 55 Leiterkernen hergestellt, dessen Leiterquerschnitt dem eines bekannten Bandleiters (vgl. *"IEEE Trans. Appl. Supercond."*, *Vol. 7, No. 2, Juni 1997, Seiten 355 bis 358*) weitgehend entsprach. Hierzu wurde erfindungsgemäß eine progressiv zunehmende Rohleiterumformung durch mehrere Walzschritte vorgenommen. Die in der Banddicke gemessene, sukzessive Dickenabnahme eines etwa zentralen Leiterkerns betrug dabei im einzelnen:

$$d_1 = 0{,}95 \cdot d_0,$$

$$d_2 = 0,85 \cdot d_0,$$

$$d_3 = 0,7 \cdot d_0,$$

$$d_4 = 0,5 \cdot d_0.$$

Das Leiterendprodukt wies dann eine kritische Stromdichte von über 50 kA/cm$^2$ auf.

Bei dem vorstehend erläuterten Ausführungsbeispiel wurde davon ausgegangen, daß der Flachbearbeitungsprozeß aus mindestens zwei Walzschritten besteht. Selbstverständlich können statt des Walzens auch andere bekannte Verfahren zur Flachbearbeitung wie z.B. Hämmern, Pressen, Schmieden oder Ziehen eingesetzt werden. Die einzelnen Walzschritte können auch mit Walzenpaaren durchgeführt werden, die sich hinsichtlich des Durchmessers ihrer Walzen unterscheiden.

**Patentansprüche**

1. Verfahren zur Herstellung eines langgestreckten, bandförmigen Supraleiters mit mehreren Leiterkernen, welche jeweils ein Supraleitermaterial mit einer metalloxidischen Hoch-$T_c$-Phase aufweisen und von einem normalleitenden Material umgeben sind, bei welchem Verfahren ein Leitervorprodukt mit einem von dem normalleitenden Material umgebenen, pulverförmigen Vormaterial des Supraleitermaterials erstellt wird und das Leitervorprodukt mehreren querschnittsvermindernden, das Vormaterial verdichtenden Verformungsschritten, die wenigstens zwei Flachbearbeitungsschritte umfassen, und mindestens einer Glühbehandlung unterzogen wird, **dadurch gekennzeichnet, daß** das Leitervorprodukt ($2_0$) einem ersten Flachbearbeitungsschritt derart zu unterziehen ist, daß die prozentuale Dickenabnahme des Querschnitts mindestens eines Leiterkerns ($3_0$) zwischen 3 und 10 % beträgt und ein Pulverfluß in dem Leiterkern erhalten bleibt, und daß ein folgender Flachbearbeitungsschritt derart vorzunehmen ist, daß die mit dem folgenden Flachbearbeitungsschritt erfolgte prozentuale Dickenabnahme des Querschnitts des mindestens einen Leiterkerns ($3_1$) um mindestens 5 % größer ist als die mit dem vorhergehenden ersten Flachbearbeitungsschritt.

2. Verfahren nach Anspruch 1, **dadurch gekennzeichnet, daß** mehr als zwei Flachbearbeitungsschritte vorgesehen werden.

3. Verfahren nach Anspruch 1 oder 2, **dadurch gekennzeichnet, daß** als Flachbearbeitungsschritte Walzschritte vorgesehen werden.

4. Verfahren nach Anspruch 3, **dadurch gekennzeichnet, daß** die Flachbearbeitungsschritte mit Paaren von Walzen vorgenommen werden, die sich im Durchmesser ihrer Walzen unterscheiden.

5. Verfahren nach einem der vorangehenden Ansprüche, **dadurch gekennzeichnet, daß** der auf den ersten Flachbearbeitungsschritt folgende Flachbearbeitungsschritt oder einer der folgenden Flachbearbeitungsschritte eine Dickenreduktion hervorruft, die um mindestens 20 % größer ist als die des ersten Flachbearbeitungsschrittes.

6. Verfahren nach einem der vorangehenden Ansprüche, **dadurch gekennzeichnet, daß** das Leitervorprodukt nach einer Pulver-im-Rohr-Technik erstellt wird und mittels mindestens eines querschnittsvermindernden Verformungsschrittes zu einem Rohleiter verarbeitet wird, der den Flachbearbeitungsschritten unterzogen wird.

7. Verfahren nach einem der vorangehenden Ansprüche, **dadurch gekennzeichnet, daß** ein Ag zumindest enthaltendes Material als normalleitendes Material vorgesehen wird.

8. Verfahren nach einem der vorangehenden Ansprüche, **gekennzeichnet durch** eine Ausbildung der Leiterkerne ($3_2$) mit einer Hoch-$T_c$-Phase aus einem supraleitenden Bi-Cuprat.

**Claims**

1. Method for the production of an elongated, tape-shaped superconductor with a plurality of conductor cores each comprising a superconductor material with a high $T_c$ metal oxide phase and surrounded by a normal-conducting material, in which method a conductor precursor is produced from a pulverulent precursor of the superconductor material surrounded by the normal-conducting material and the conductor precursor is subjected to a plurality of section-reducing forming steps compacting the precursor and including at least two flattening steps, and to at least one annealing operation, **characterised in that** the conductor precursor ($2_0$) is to be subjected to a first flattening step in such a manner that the percentage reduction in the thickness of the cross section of at least one conductor core ($3_0$) is between 3 and 10 % and a powder flow is maintained in the conductor core and that a subsequent flattening step is to be effected in such a manner that the percentage reduction in the thickness of the cross section of the at least one conductor core ($3_1$) effected by the subsequent flattening step is at least 5 % greater than that effected by the preceding first flattening step.

2. Method according to claim 1, **characterised in that** more than two flattening steps are provided.

3. Method according to claim 1 or claim 2, **characterised in that** rolling steps are provided as the flattening steps.

4. Method according to claim 3, **characterised in that** the flattening steps are carried out by pairs of rolls with different diameters.

5. Method according to one of the preceding claims, **characterised in that** the flattening step following the first flattening step or one of the subsequent flattening steps effects a reduction in thickness at least 20 % greater than that of the first flattening step.

6. Method according to one of the preceding claims, **characterised in that** the conductor precursor is produced by a powder-in-tube technique and is processed by means of at least one section-reducing forming step to form a precursor conductor which is subjected to the flattening steps.

7. Method according to one of the preceding claims, **characterised in that** a material at least containing Ag is provided as the normal-conducting material.

8. Method according to one of the preceding claims, **characterised by** the formation of the conductor cores ($3_2$) with a high $T_c$ phase from a superconducting bismuth cuprate.

**Revendications**

1. Procédé de fabrication d'un supraconducteur en forme de ruban allongé ayant plusieurs noyaux conducteurs avec une matière supraconductrice métaloxyde à phase à haute température critique Tc et entourée d'une matière à conduction normale, procédé selon lequel on réalise un conducteur semifini avec une matière première à état de poudre de matière supraconductrice entourée par une matière normalement conductrice et on soumet le conducteur semi-fini à plusieurs étapes de transformation de compression de la matière première avec réduction de la section, ces étapes comprenant au moins deux étapes de travail à plat et au moins un traitement de recuit,
**caractérisé en ce que**
l'on soumet le conducteur semi-fini ($2_0$) à une première étape de travail à plat de façon que la diminution d'épaisseur en pourcentage de la section d'au moins un noyau conducteur ($3_0$) représente entre 3 et 10% et que le fluage dé la poudre dans le noyau conducteur reste maintenu et on effectue une étape de travail à plat suivante de façon que la diminution d'épaisseur en pourcentage de la section faite au cours de cette étape de travail à plat suivante, pour au moins un noyau conducteur ($3_1$) soit d'au moins 5% supérieure à la réduction effectuée au cours de la première étape de travail à plat.

2. Procédé selon la revendication 1,
**caractérisé en ce qu'**
il y a plus de deux étapes de travail à plat.

3. Procédé selon la revendication 1 ou 2,
**caractérisé en ce que**
les étape de travail à plat sont des étapes de laminage.

4. Procédé selon la revendication 3,
**caractérisé en ce qu'**
on effectue les étapes de travail à plat avec des paires de cylindres qui se distinguent par leur diamètre.

5. Procédé selon l'une des revendications précédentes,
**caractérisé en ce que**
l'étape de travail à plat qui suit la première étape de travail à plat ou une étape suivante produit une réduction de l'épaisseur qui est au moins 20% supérieure à celle de la première étape.

6. Procédé selon l'une des revendications précédentes,
**caractérisé en ce qu'**
on réalise le conducteur semi-fini selon la technique de la poudre dans un tube et on traite à l'aide d'au moins une étape de transformation avec réduction de section pour obtenir un conducteur tubulaire que l'on soumet à une étape de travail à plat.

7. Procédé selon l'une des revendications précédentes,
**caractérisé en ce que**
la matière à conduction normale est une matière contenant au moins Ag.

8. Procédé selon l'une des revendications précédentes,
**caractérisé par**
une réalisation des noyaux conducteurs ($3_2$) ayant une phase à température critique élevée Tc formée de bicuprate supraconducteur.

**FIG 1**

$d_0$

4

$3_0$

$\underline{2_0}$

**FIG 2**

$d_1$

4

$3_1$

$\underline{2_1}$

**FIG 3**

$d_2$

4

$3_2$

$\underline{2_2}$